(19) Europäisches Patentamt / European Patent Office / Office européen des brevets

(11) **EP 2 430 491 B1**

(12) **EUROPÄISCHE PATENTSCHRIFT**

(45) Veröffentlichungstag und Bekanntmachung des Hinweises auf die Patenterteilung:
**16.12.2015   Patentblatt 2015/51**

(21) Anmeldenummer: **10721689.7**

(22) Anmeldetag: **12.05.2010**

(51) Int Cl.:
**G02B 27/09** $^{(2006.01)}$        **H01S 5/0683** $^{(2006.01)}$

(86) Internationale Anmeldenummer:
**PCT/EP2010/002896**

(87) Internationale Veröffentlichungsnummer:
**WO 2010/130415 (18.11.2010 Gazette 2010/46)**

(54) **VORRICHTUNG ZUR FORMUNG VON LASERSTRAHLUNG SOWIE LASERVORRICHTUNG MIT EINER DERARTIGEN VORRICHTUNG**

DEVICE FOR BEAMSHAPING AND CORRESPONDING LASERDEVICE

DISPOSITIF POUR LA MISE EN FORME DE RAYONNEMENT LASER ET DISPOSITIF LASER CORRESPONDANT

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **14.05.2009   DE 102009021251**

(43) Veröffentlichungstag der Anmeldung:
**21.03.2012   Patentblatt 2012/12**

(73) Patentinhaber: **LIMO Patentverwaltung GmbH & Co. KG**
**44319 Dortmund (DE)**

(72) Erfinder:
• **MIKHAILOV, Alexei**
  **44319 Dortmund (DE)**

• **KOLOTUSHKIN, Yury**
  **199155 St. Petersburg (RU)**

(74) Vertreter: **Basfeld, Rainer et al**
**Fritz Patent- und Rechtsanwälte**
**Partnerschaft mbB**
**Apothekerstraße 55**
**59755 Arnsberg (DE)**

(56) Entgegenhaltungen:
| | |
|---|---|
| **EP-A2- 1 574 892** | **WO-A1-2007/043597** |
| **WO-A1-2008/087012** | **US-A- 5 469 423** |
| **US-A- 5 796 521** | **US-A1- 2007 268 794** |
| **US-A1- 2008 273 123** | |

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft eine Vorrichtung zur Formung von Laserstrahlung gemäß dem Oberbegriff des Anspruchs 1 und eine Laservorrichtung gemäß dem Oberbegriff des Anspruchs 9.

Definitionen: In Ausbreitungsrichtung der Laserstrahlung meint mittlere Ausbreitungsrichtung der Laserstrahlung, insbesondere wenn diese keine ebene Welle ist oder zumindest teilweise divergent ist. Mit Laserstrahl, Lichtstrahl, Teilstrahl oder Strahl ist, wenn nicht ausdrücklich anderes angegeben ist, kein idealisierter Strahl der geometrischen Optik gemeint, sondern ein realer Lichtstrahl, wie beispielsweise ein Laserstrahl mit einem Gauß-Profil oder einem modifizierten Gauß-Profil oder einem Top-Hat-Profil, der keinen infinitesimal kleinen, sondern einen ausgedehnten Strahlquerschnitt aufweist. Mit Top-Hat-Verteilung oder Top-Hat-Intensitätsverteilung oder Top-Hat-Profil ist eine Intensitätsverteilung gemeint, die sich zumindest hinsichtlich einer Richtung im Wesentlichen durch eine Rechteckfunktion (rect (x)) beschreiben lässt. Dabei sollen reale Intensitätsverteilungen, die Abweichungen von einer Rechteckfunktion im Prozentbereich beziehungsweise geneigte Flanken aufweisen, ebenfalls als Top-Hat-Verteilung oder Top-Hat-Profil bezeichnet werden können.

Eine Vorrichtung zur Formung von Laserstrahlung der eingangs genannten Art und eine Laservorrichtung der eingangs genannten Art sind aus der WO 2007/122061 A1 bekannt. Mit der darin beschriebenen Vorrichtung soll in einer Arbeitsebene eine linienförmige Intensitätsverteilung der Laserstrahlung erzeugt werden. Bei der Vorrichtung treten zwei Laserstrahlungen jeweils durch einen zweistufigen Homogenisator hindurch, der zwei Arrays mit jeweils drei Linsen umfasst. Die beiden Laserstrahlungen und die Homogenisatoren sind in der Längsrichtung der zu erzeugenden Linie voneinander beabstandet. Hinter den beiden Homogenisatoren sind zwei Linsen vorgesehen, die ebenfalls in der Längsrichtung der zu erzeugenden Linie voneinander beabstandet sind, wobei durch jede der Linsen eine der Laserstrahlungen hindurchtreten kann. In einer Arbeitsebene hinter den Linsen werden die Laserstrahlungen zu einer linienförmigen Intensitätsverteilung überlagert.

Eine weitere Vorrichtung zur Formung von Laserstrahlung sowie eine Laservorrichtung mit einer derartigen Vorrichtung sind aus der US 2007/0268794 A1 bekannt. Bei der darin beschriebenen Vorrichtung ist hinter einem ersten, der Homogenisierung dienenden Linsenarray ein zweites, der teilweisen Überlagerung dienendes Linsenarray vorgesehen. Eine jede der Linsen des zweiten Linsenarrays kann dabei Teilstrahlen aus jeweils drei Linsen des ersten Linsenarrays zusammenfassen. Es ist weiterhin hinter dem zweiten Linsenarray eine Linse vorgesehen, die das Licht der einzelnen Teilstrahlen in einer Arbeitsebene in verschiedene Bereiche ablenkt.

Eine weitere Vorrichtung zur Formung von Laserstrahlung und eine weitere Laservorrichtung sind aus der WO 2008/006460 A1 bekannt. Bei der darin beschriebenen Vorrichtung ist als Homogenisatormittel ein Linsenarray vorgesehen, dessen Linsen unterschiedlich breit sind. Insbesondere nimmt die Breite der Linsen vom Rand zur Mitte hin ab. Dadurch wird eine Top-Hat-Winkelverteilung mit trapezähnlich abfallenden Flanken der durch die Homogenisatormittel hindurch getretenen Laserstrahlung erreicht. Mehrere Lasermodule mit derartigen Homogenisatormitteln können so nebeneinander angeordnet werden, dass deren Laserstrahlungen in einer Arbeitsebene zu einer homogenen linienförmigen Intensitätsverteilung überlappen.

Als nachteilig bei diesem Stand der Technik erweist sich die Tatsache, dass eine Top-Hat-Winkelverteilung mit trapezähnlich abfallenden Flanken benötigt wird. Um diese zu erzielen, müssen die Homogenisatormittel aufwendig gestaltet werden, indem die Mittenabstände (Pitch) der Linsen von außen nach innen abnehmen.

Das der vorliegenden Erfindung zugrunde liegende Problem ist die Schaffung einer Vorrichtung zur Formung von Laserstrahlung der eingangs genannten Art und einer Laservorrichtung der eingangs genannten Art die, insbesondere hinsichtlich der Gestaltung der Homogenisatormittel, einfacher und/oder kostengünstiger aufgebaut sind.

Dies wird erfindungsgemäß durch eine Vorrichtung zur Formung von Laserstrahlung der eingangs genannten Art mit den kennzeichnenden Merkmalen des Anspruchs 1 sowie durch eine Laservorrichtung der eingangs genannten Art mit den kennzeichnenden Merkmalen des Anspruchs 9 erreicht. Die Unteransprüche betreffen bevorzugte Ausgestaltungen der Erfindung.

Gemäß Anspruch 1 ist vorgesehen, dass das Linsenarray der Überlagerungsmittel ein einstückiges Linsenarray ist.

Für die Linsen des Linsenarrays gilt folgende Bedingung:

$$2 \cdot F \cdot NA(50\%) = M \cdot P_2$$

mit M=1, 2, 3, ...,

wobei F die Brennweite einer jeder der Linsen ist,

wobei $P_2$ der Mittenabstand der Linsen ist,

und wobei NA(50%) die numerische Apertur einer jeder der Linsen ist, definiert über denjenigen Winkel, bei dem die Intensität durch die Linsen hindurchtretenden Lichts auf die Hälfte abgefallen ist. Durch Einhaltung dieser Bedingung und das gleichzeitige Vorsehen einer Rückkopplung durch Steuermittel lassen sich sehr homogene Intensitätsverteilungen erzielen.

Dementsprechend besteht die Möglichkeit, dass die Vorrichtung weiterhin Steuermittel umfasst, die derart Einfluss auf die Laserstrahlung nehmen können, dass die Intensität eines jeden der aus den Homogenisierungsmitteln austretenden Teilstrahlen oder einer jeden der aus den Homogenisierungsmitteln austretenden Gruppen von Teilstrahlen gleich groß ist. Beide Maßnahmen können dazu dienen, eine homogene Überlagerung der einzelnen Teilstrahlen oder Gruppen von Teilstrahlen in der Arbeitsebene zu gewährleisten, ohne dass die Flanken der Winkelverteilungen trapezähnlich abfallen müssen beziehungsweise ohne dass die Homogenisatormittel sich verändernde Mittenabstände der Linsen aufweisen müssen. Bei der vorliegenden Erfindung reicht es aus, wenn die Flanken abfallen und die Winkelverteilungen symmetrisch sind.

Mit der vorliegenden Erfindung lassen sich im Prinzip beliebig lange linienförmige Intensitätsverteilungen erzeugen. Weiterhin wird die Güte der Homogenität nur durch die Fertigungstoleranzen bei der Herstellung der Linsenarrays für die Homogenisatormittel und/oder die Überlagerungsmittel beeinträchtigt. Eine große Homogenität kann ohne aufwendiges Justieren erreicht werden.

Es kann vorgesehen sein, dass für die Laserstrahlung und für die Linsen des Linsenarrays folgende Bedingung gilt:

$$\frac{w_0}{d} > 1,1$$

wobei $w_0$ der Abstand in der Arbeitsebene zwischen der maximalen Intensität und der auf $1/e^2$ abgefallenen Intensität der von einer der Linsen erzeugten Intensitätsverteilung ist,

und wobei d der Abstand in der Arbeitsebene zwischen den maximalen Intensitäten der von zwei benachbarten Linsen erzeugten Intensitätsverteilungen ist. Vorteilhaft bei dieser Ausführungsform ist einerseits, dass auch gaußähnliche Winkelverteilungen der Teilstrahlen oder Gruppen von Teilstrahlen so überlagert werden können, dass homogene Linien entstehen. Andererseits muss die Forderung wo/d>1,1 nicht so strikt wie die Forderung $2 \cdot F \cdot NA(50\%) = M \cdot P_2$ eingehalten werden, so dass der Aufbau einer derartigen Vorrichtung einfacher sein kann.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen

Fig. 1 eine schematische Draufsicht auf eine erste Ausführungsform einer erfindungsgemäßen Vorrichtung zur Formung von Laserstrahlung, wobei die Intensitätsverteilung einer Gruppe von Teilstrahlen in der Arbeitsebene verdeutlicht ist;

Fig. 2 eine schematische Draufsicht auf die erste Ausführungsform, wobei die Gesamtintensitätsverteilung sämtlicher Gruppen von Teilstrahlen in der Arbeitsebene verdeutlicht ist;

Fig. 3 eine schematische Draufsicht auf eine zweite Ausführungsform einer erfindungsgemäßen Vorrichtung zur Formung von Laserstrahlung, wobei die Gesamtintensitätsverteilung sämtlicher Gruppen von Teilstrahlen in der Arbeitsebene verdeutlicht ist;

Fig. 4 eine schematische Draufsicht auf eine dritte Ausführungsform einer erfindungsgemäßen Vorrichtung zur Formung von Laserstrahlung, wobei die Intensitätsverteilung einer Gruppe von Teilstrahlen in der Arbeitsebene verdeutlicht ist;

Fig. 5 eine schematische Draufsicht auf die dritte Ausführungsform, wobei die Gesamtintensitätsverteilung sämtlicher Gruppen von Teilstrahlen in der Arbeitsebene verdeutlicht ist;

Fig. 6 eine schematische Draufsicht auf eine vierte Ausführungsform einer erfindungsgemäßen Vorrichtung zur Formung von Laserstrahlung, wobei die Intensitätsverteilung einer Gruppe von Teilstrahlen in der Arbeitsebene verdeutlicht ist;

Fig. 7 eine schematische Draufsicht auf die vierte Ausführungsform, wobei die Gesamtintensitätsverteilung sämtlicher Gruppen von Teilstrahlen in der Arbeitsebene verdeutlicht ist;

Fig. 8 eine schematische Detail-Draufsicht auf eine erfindungsgemäße Laservorrichtung mit einer fünften Ausführungsform einer erfindungsgemäßen Vorrichtung zur Formung von Laserstrahlung;

Fig. 9 eine schematische Detail-Seitenansicht der Laservorrichtung gemäß Fig. 8.

In den Figuren sind gleiche oder funktional gleiche Teile oder Lichtstrahlen oder Intensitätsverteilungen oder Bemaßungen mit gleichen Bezugszeichen versehen. Weiterhin ist in einigen der Figuren zur besseren Übersichtlichkeit ein kartesisches Koordinatensystem eingezeichnet.

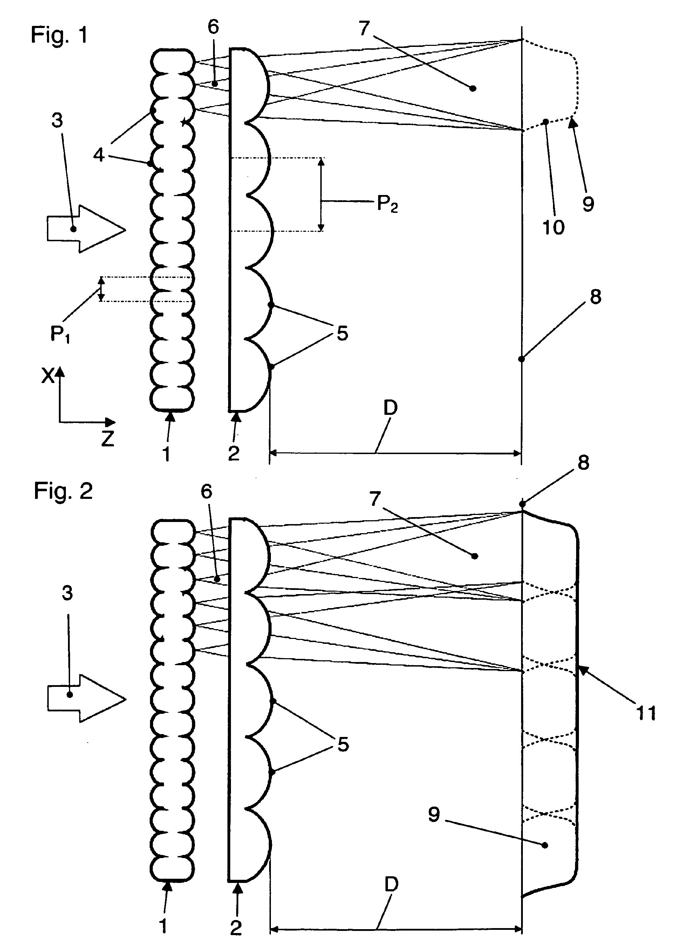

Die in Fig. 1 und Fig. 2 abgebildete Ausführungsform einer erfindungsgemäßen Vorrichtung umfasst Homogenisatormittel 1 und Überlagerungsmittel 2. Dabei sind die Überlagerungsmittel 2 in Ausbreitungsrichtung Z der zu formenden Laserstrahlung 3 hinter den Homogenisatormitteln 1 angeordnet.

Die Homogenisatormittel 1 sind als einstückiges Linsenarray ausgebildet und umfassen eine Mehrzahl von in X-Richtung nebeneinander angeordneten Linsen 4. Es kann sich dabei um Zylinderlinsen mit sich in Y-Richtung erstreckenden Zylinderachsen, aber auch um sphärische Linsen handeln.

Die Überlagerungsmittel 2 sind ebenfalls als einstückiges Linsenarray ausgebildet und umfassen ebenfalls eine Mehrzahl von in X-Richtung nebeneinander angeordneten Linsen 5. Auch hierbei kann es sich um Zylinderlinsen mit sich in Y-Richtung erstreckenden Zylinderachsen, aber auch um sphärische Linsen handeln. Jede der Linsen 5 kann die gleiche Brennweite F aufweisen.

Im abgebildeten Ausführungsbeispiel weisen die Überlagerungsmittel 2 fünf Linsen 5 auf. Es besteht durchaus die Möglichkeit, eine größere, insbesondere eine deutlich größere Anzahl von Linsen 5 vorzusehen, wobei dann auch entsprechend die Anzahl der Linsen 4 der Homogenisatormittel 1 größer ist.

In dem abgebildeten Ausführungsbeispiel ist die Breite der Linsen 5 der Überlagerungsmittel 2 um einen Faktor drei größer als die Breite der Linsen 4 der Homogenisatormittel 1, so dass einer jeden der Linsen 5 der Überlagerungsmittel 2 drei Linsen 4 der Homogenisatormittel 1 zugeordnet sind. Entsprechend gilt für den Mittenabstand (Pitch) $P_1$ der Linsen 4 und den Mittenabstand $P_2$ der Linsen 5 die Beziehung $3 \cdot P_1 = P_2$ (siehe Fig. 1).

Es besteht durchaus die Möglichkeit, kleinere oder größere Linsen 4 der Homogenisatormittel 1 vorzusehen. Insbesondere besteht die Möglichkeit, eine größere Anzahl von Linsen 4 der Homogenisatormittel 1 einer jeden der Linsen 5 der Überlagerungsmittel 2 zuzuordnen.

Die zu formende Laserstrahlung 3 soll in dem abgebildeten Ausführungsbeispiel bei dem Auftreffen auf die Homogenisatormittel 1 eine linienförmige Intensitätsverteilung aufweisen, wobei die Linienlänge dieser linienförmige Intensitätsverteilung in X-Richtung etwa der Länge der Homogenisatormittel 1 in X-Richtung entspricht.

Die Laserstrahlung 3 wird von den Linsen 4 der Homogenisatormittel 1 in eine Mehrzahl von Teilstrahlen 6 aufgespalten. Jeweils eine Gruppe 7 von drei Teilstrahlen 6 treten gemeinsam durch eine der Linsen 5 der Überlagerungsmittel 2 hindurch. In einer Arbeitsebene 8, die in einem Abstand D von den Linsen 5 der Überlagerungsmittel 2 angeordnet ist, der der Brennweite F der Linsen 5 entspricht, werden die drei Teilstrahlen 6 einer jeden Gruppe 7 zu einer linienförmigen Intensitätsverteilung 9 überlagert (siehe Fig. 1).

Die Intensitätsverteilung 9 hat im Wesentlichen die Form einer Top-Hat-Verteilung, die allerdings keine unendlich steil abfallenden Flanken 10, sondern vergleichsweise moderat abfallende Flanken 10 aufweist (siehe Fig. 1). Die Form der Intensitätsverteilung 9 wird durch die Gestaltung der Homogenisatormittel 1, insbesondere durch die Gestaltung einer jeder der einzelnen Linsen 4 der Homogenisatormittel 1 vorgegeben.

Fig. 2 verdeutlicht, dass die Homogenisatormittel 1 und die Überlagerungsmittel 2 derart gestaltet und angeordnet sind, dass in der Arbeitsebene 8 die Intensitätsverteilungen 9 der einzelnen Gruppen 8 von Teilstrahlen 7 jeweils bei 50% der maximalen Intensität der einzelnen Intensitätsverteilungen 9 überlappen. Dadurch ergibt sich eine sehr homogene Gesamtintensitätsverteilung 11.

Die Bedingung für den weitgehend oszillationsfreien Überlapp der einzelnen Intensitätsverteilungen 9 zu einer Gesamtintensitätsverteilung 11 kann als

$$2 \cdot F \cdot NA(50\%) = P_2$$

geschrieben werden. Dabei ist NA(50%) die numerische Apertur einer jeder der Linsen 5, definiert über denjenigen Winkel, bei dem die Intensität durch die Linsen 5 hindurchtretenden Lichts auf die Hälfte abgefallen ist.

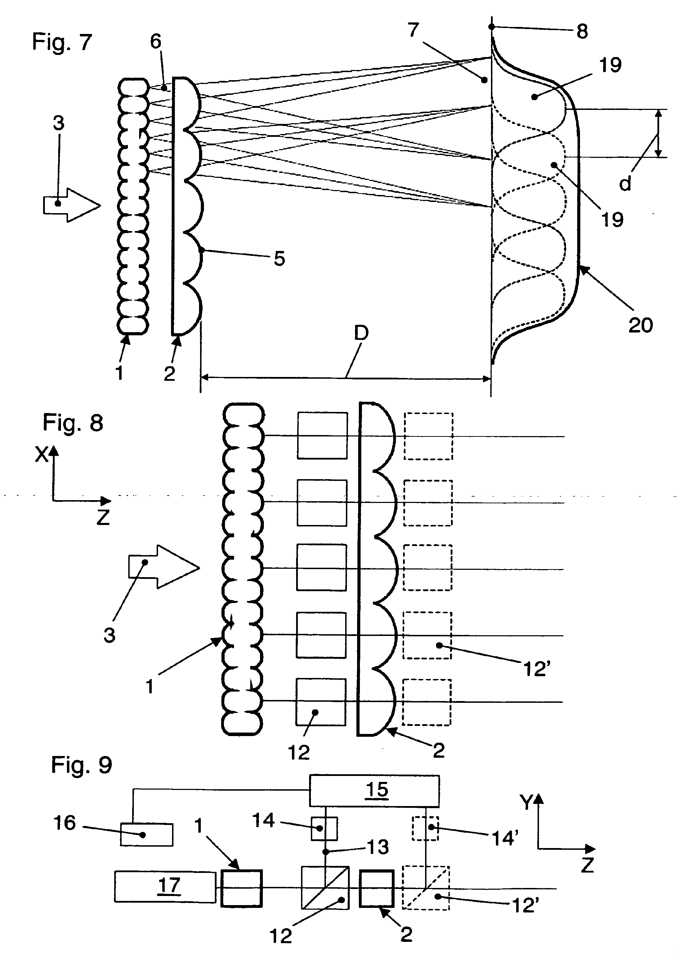

Eine zusätzliche Bedingung ist, dass die Intensitäten der einzelnen Gruppen 7 von Teilstrahlen 6 in der Arbeitsebene 8 gleich groß sind. Dies kann durch eine Anordnung erreicht werden, wie sie in der Laservorrichtung gemäß Fig. 8 und Fig. 9 abgebildet ist.

Bei dieser Laservorrichtung sind zwischen den Homogenisatormitteln 1 und den Überlagerungsmitteln 2 eine Mehrzahl von Strahlteilern 12 vorgesehen, wobei die Anzahl der Strahlteiler 12 der Anzahl der Linsen 5 der Überlagerungsmittel 2 entspricht. Durch die Strahlteiler 12 wird jeweils ein kleiner Anteil 13 des Lichtes einer Gruppe 7 von Teilstrahlen 6 aus der Ausbreitungsrichtung Z nach oben in Fig. 9 beziehungsweise in Y-Richtung abgelenkt.

Diese Anteile 13 der Laserstrahlung 3 treffen auf eine Mehrzahl von Sensormitteln 14, die jeweils die Intensität einer der Gruppen 7 von Teilstrahlen 6 erfassen können. Die Laservorrichtung umfasst weiterhin Komparationsmittel 15, die die von den Sensormitteln 14 erfassten Intensitäten der einzelnen Gruppen 7 von Teilstrahlen 6 miteinander vergleichen können. Die Komparationsmittel 15 können eine Stromversorgung 16 einer oder mehrerer in Fig. 9 schematisch angedeuteter Laserlichtquellen 17 derart ansteuern, dass die Intensitäten der Gruppen 7 von Teilstrahlen 6 aneinander angeglichen werden.

Auf diese Weise kann erreicht werden, dass durch jede der Linsen 5 der Überlagerungsmittel 2 Laserstrahlung gleicher Leistung hindurchtritt. Dies führt zu der sehr homogenen linienförmigen Gesamtintensitätsverteilung 11 wie sie in Fig. 2 abgebildet ist.

In Fig. 8 und Fig. 9 sind gestrichelt Strahlteiler 12' und Sensormittel 14' angedeutet, die alternativ zu den durchgezogen dargestellten Strahlteilern 12 und Sensormitteln 14 hinter den Überlagerungsmitteln 2 vorgesehen sein können.

Die Sensormittel 14 können als Fotodiode, Fotowiderstand, Fototransistor, Fotozelle oder dergleichen ausgebildet sein.

Die vorgenannten Strahlteiler 12, 12', Sensormittel 14, 14' und Komparationsmittel 15 bilden insgesamt Steuermittel, die gleiche Leistungen beziehungsweise Intensitäten der Gruppen 7 von Teilstrahlen 6 in der Arbeitsebene 8 gewährleisten. Diese Steuermittel können bei sämtlichen in den Figuren 2 bis 7 abgebildeten Ausführungsformen ebenfalls vorgesehen sein.

Bei den Ausführungsformen gemäß Fig. 1 und Fig. 2 sind die Linsen 4 der Homogenisatormittel 1 derart gestaltet, dass das Richtdiagramm beziehungsweise die Winkelverteilung der Gruppen 7 von Teilstrahlen 6 moderat abfallende Flanken aufweisen. Die Überlagerung in einem Abstand D=F hinter den Linsen 5 ergibt dann die in Fig. 1 und Fig. 2 abgebildeten Intensitätsverteilungen 9.

Es ist jedoch erfindungsgemäß auch möglich, die Linsen 4 der Homogenisatormittel 1 derart zu gestalten, dass das Richtdiagramm beziehungsweise die Winkelverteilung der Gruppen 7 von Teilstrahlen 6 annähernd unendlich steil abfallende Flanken aufweisen beziehungsweise einer idealen Top-Hat-Winkelverteilung sehr nahe kommen. In diesem Fall wird dann die Arbeitsebene 8 nicht im Abstand D=F hinter den Linsen 5 gewählt, sondern im Abstand D=F+$\delta$. Dabei ist die zusätzliche Distanz $\delta$ so zu wählen, dass in der Arbeitsebene 9 eine überlagerte Intensitätsverteilung 9 der einzelnen Gruppen 7 von Teilstrahlen 6 weniger steil abfallende Flanken 10 aufweist.

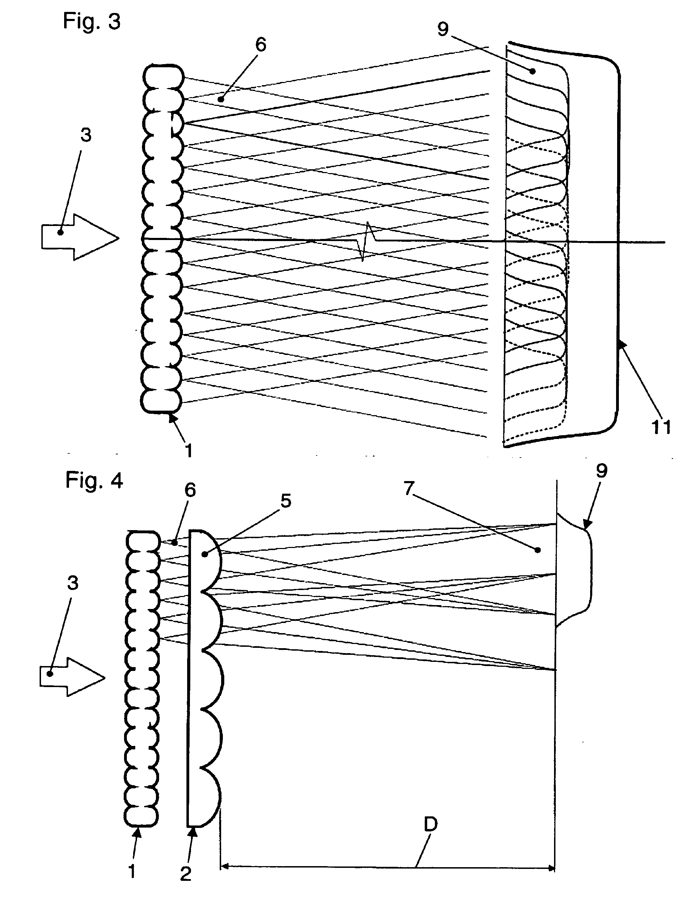

Fig. 3 zeigt eine Ausführungsform, bei der auf die Überlagerungsmittel 2 verzichtet wird. Die Überlagerung der Gruppen 7 von Teilstrahlen 6 findet dann im Fernfeld, also in einer großen Entfernung zu den Homogenisatormitteln 1 statt.

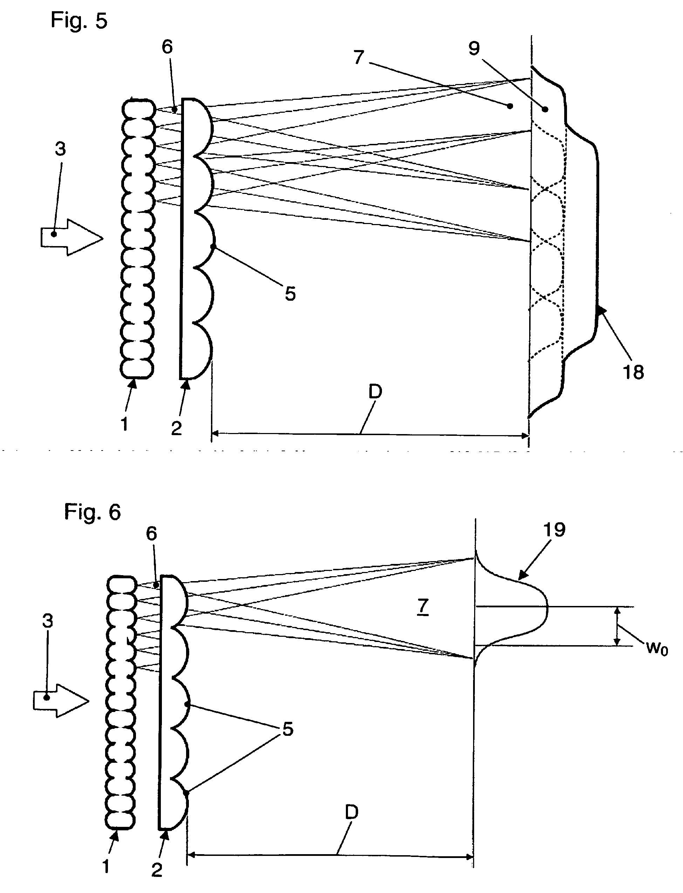

Fig. 4 und Fig. 5 zeigen eine Ausführungsform, bei der die Brennweite F der Linsen 5 der Überlagerungsmittel 2 größer ist als bei der Ausführungsform gemäß den Fig. 1 und Fig. 2. Dies hat zur Folge, dass die Intensitätsverteilungen 9 der einzelnen Gruppen 7 von Teilstrahlen 6 in der Arbeitsebene 8 breiter sind. Wenn die Bedingung

$$2 \cdot F \cdot NA(50\%) = M \cdot P_2$$

mit M=1, 2, 3, ... erfüllt ist, ergibt sich trotzdem eine oszillationsfreie Überlagerung der Intensitätsverteilungen 9 zu einer Gesamtintensitätsverteilung 18 (siehe Fig. 5). Fig. 4 und Fig. 5 zeigen den Fall, bei dem M=2 ist.

Bei der Ausführungsform gemäß den Fig. 6 und Fig. 7 sind die Linsen 4 der Homogenisatormittel 1 derart gestaltet, dass das Richtdiagramm beziehungsweise die Winkelverteilung der Gruppen 7 von Teilstrahlen 6 zwar moderat abfallende Flanken aber keine Winkelbereiche konstanter Intensität aufweisen. Die Überlagerung in einem Abstand D=F hinter den Linsen 5 ergibt dann die in Fig. 6 und Fig. 7 abgebildeten Intensitätsverteilungen 19 ohne ausgeprägten Plateaubereich, die einer Gauß-Verteilung ähneln.

Die Bedingung für die Überlagerung zu einer Gesamtintensitätsverteilung 20 mit Inhomogenitäten kleiner 1 % ist:

$$\frac{w_0}{d} > 1,1.$$

Hier ist $w_0$ der Abstand in der Arbeitsebene 8 zwischen der maximalen Intensität und der auf $1/e^2$ abgefallenen Intensität der von einer der Linsen 5 erzeugten Intensitätsverteilung 19 und d der Abstand in der Arbeitsebene 8 zwischen den maximalen Intensitäten der von zwei benachbarten Linsen 5 erzeugten Intensitätsverteilungen 19.

**Patentansprüche**

1. Vorrichtung zur Formung von Laserstrahlung (3), umfassend

   - Homogenisierungsmittel (1), die eine Mehrzahl von Teilstrahlen (6) oder eine Mehrzahl von Gruppen (7) von Teilstrahlen (6) der Laserstrahlung (3) separat homogenisieren können, derart, dass die von den Homogenisierungsmitteln (1) ausgehenden Teilstrahlen (6) oder Gruppen (7) von Teilstrahlen (6) in einer Arbeitsebene (8) jeweils eine linienförmige Intensitätsverteilung (9, 19) mit an den Linienenden endlich steil abfallenden Flanken (10) erzeugen können,
   - Überlagerungsmittel (2), die ein Linsenarray mit einer Mehrzahl von in einer Anordnungsrichtung nebeneinander angeordneten Linsen (5) umfassen, wobei die Überlagerungsmittel (2) zur Überlagerung der Teilstrahlen (6) oder Gruppen (7) von Teilstrahlen (6) dienen, derart, dass in der Arbeitsebene (8) eine linienförmige Intensitätsverteilung (11, 20) erzeugt werden kann, deren Länge in der Anordnungsrichtung der Linsen (5) größer ist als die Länge einer jeden der linienförmigen Intensitätsverteilungen (9, 19) der Teilstrahlen (6) oder Gruppen (7) von Teilstrahlen (6) in der Anordnungsrichtung der Linsen (5),
   - wobei für die Linsen (5) des Linsenarrays folgende Bedingung gilt:

$$2 \cdot F \cdot NA(50\%) = M \cdot P_2$$

- mit M=1 , 2, 3, ...,

   - wobei F die Brennweite einer jeder der Linsen ist,
   - wobei $P_2$ der Mittenabstand der Linsen ist,
   - und wobei NA(50%) die numerische Apertur einer jeder der Linsen (5) ist, definiert über denjenigen Winkel, bei dem die Intensität durch die Linsen (5) hindurchtretenden Lichts auf die Hälfte abgefallen ist,

   - wobei die Homogenisierungsmittel (1) und/oder das Linsenarray derart angeordnet und/oder ausgebildet sind, dass durch jede der Linsen (5) einer der Teilstrahlen (6) oder eine Gruppe (7) von Teilstrahlen (6) hindurchtritt,

   **dadurch gekennzeichnet, dass** das Linsenarray der Überlagerungsmittel (2) ein einstückiges Linsenarray ist.

2. Vorrichtung nach Anspruch 1, **dadurch gekennzeichnet, dass** die Vorrichtung weiterhin Steuermittel umfasst, die derart Einfluss auf die Laserstrahlung (3) nehmen können, dass die Intensität eines jeden der aus den Homogenisierungsmitteln (1) austretenden Teilstrahlen (6) oder einer jeden der aus den Homogenisierungsmitteln (1) austretenden Gruppen (7) von Teilstrahlen (6) gleich groß ist.

3. Vorrichtung nach einem der Ansprüche 1 oder 2, **dadurch gekennzeichnet, dass** sämtliche Linsen (5) des Linsenarrays die gleiche Brennweite aufweisen.

4. Vorrichtung nach einem der Ansprüche 1 bis 3, **dadurch gekennzeichnet, dass** sämtliche Linsen (5) des Linsenarrays die gleiche Breite und/oder den gleichen Mittenabstand ($P_2$) aufweisen.

5. Vorrichtung nach einem der Ansprüche 1 bis 4, **dadurch gekennzeichnet, dass** für die Laserstrahlung (3) und für die Linsen (5) des Linsenarrays folgende Bedingung gilt:

$$\frac{w_0}{d} > 1,1$$

- wobei $w_0$ der Abstand in der Arbeitsebene (8) zwischen der maximalen Intensität und der auf $1/e^2$ abgefallenen Intensität der von einer der Linsen (5) erzeugten Intensitätsverteilung (19) ist,
- und wobei d der Abstand in der Arbeitsebene (8) zwischen den maximalen Intensitäten der von zwei benachbarten Linsen (5) erzeugten Intensitätsverteilungen (19) ist.

6. Vorrichtung nach einem der Ansprüche 1 bis 5, **dadurch gekennzeichnet, dass** die Steuermittel Sensormittel (14) umfassen, die die Intensität eines jeden der aus den Homogenisierungsmitteln (1) austretenden Teilstrahlen (6) oder Gruppen (7) von Teilstrahlen (6) erfassen können.

7. Vorrichtung nach Anspruch 6, **dadurch gekennzeichnet, dass** die Sensormittel (14) als Fotodiode, Fotowiderstand, Fototransistor, Fotozelle oder dergleichen ausgebildet sind.

8. Vorrichtung nach einem der Ansprüche 1 bis 7, **dadurch gekennzeichnet, dass** die Steuermittel Komparationsmittel (15) umfassen, die die Intensitäten der aus den Homogenisierungsmitteln (1) austretenden Teilstrahlen (6) oder Gruppen (7) von Teilstrahlen (6) vergleichen können.

9. Laservorrichtung, umfassend

   - mindestens eine Laserlichtquelle (17),
   - eine Vorrichtung zur Formung von Laserstrahlung (3) gemäß dem Oberbegriff des Anspruchs 1,

   **dadurch gekennzeichnet, dass** die Vorrichtung zur Formung von Laserstrahlung (3) eine Vorrichtung nach einem der Ansprüche 1 bis 8 ist.

10. Laservorrichtung nach Anspruch 9, **dadurch gekennzeichnet, dass** die Laservorrichtung mindestens eine Stromversorgung (16) für die mindestens eine Laserlichtquelle (17) umfasst und die Steuermittel die mindestens eine Stromversorgung (16) derart ansteuern können, dass die Intensitäten der aus den Homogenisierungsmitteln (1) austretenden Teilstrahlen (6) oder Gruppen (7) von Teilstrahlen (6) verändert werden, insbesondere aneinander angeglichen werden.

**Claims**

1. Device for shaping laser radiation (3), comprising

   - homogenizing means (1) which can homogenize a plurality of component beams (6) or a plurality of groups (7) of component beams (6) of the laser radiation (3) separately in such a way that, the component beams (6) or groups (7) of component beams (6) emanating from the homogenizing means (1) can respectively generate in an operating plane (8) a linear intensity distribution (9, 19) with finitely steeply sloping edges at the line ends, and

- superimposing means (2) which comprise a lens array with a plurality of lenses (5) arranged next to one another in an arrangement direction, the superimposing means (2) serving to superimpose the component beams (6) or groups (7) of component beams (6) in such a way that it is possible to generate in the operating plane (8) a linear intensity distribution (11, 20) whose length in the arrangement direction of the lenses (5) is greater than the length of each of the linear intensity distributions (9, 19) of the component beams (6) or groups (7) of component beams (6) in the arrangement direction of the lenses (5),

- the following condition being valid for the lenses (5) of the lens array:

$$2 \cdot F \cdot NA(50\%) = M \cdot P_2$$

- where M = 1, 2, 3, ...,
- F being the focal length of each of the lenses,
- $P_2$ being the centre-to-centre spacing of the lenses,
- and NA(50%) being the numerical aperture of each of the lenses (5), defined via that angle for which the intensity of light passing through the lenses (5) has dropped to half,

- the homogenizing means (1) and/or the lens array being arranged and/or designed in such a way that one of the component beams (6) or a group (7) of component beams (6) passes through each of the lenses (5),

**characterized in that** the lens array of the superimposing means (2) is a unipartite lens array.

2. Device according to Claim 1, **characterized in that** the device further comprises control means which are capable of influencing the laser radiation (3) in such a way that the intensity of each of the component beams (6) emerging from the homogenizing means (1), or of each of the groups (7) of component beams (6) emerging from the homogenizing means (1) is equally large.

3. Device according to either of Claims 1 and 2, **characterized in that** all the lenses (5) of the lens array have the same focal length.

4. Device according to one of Claims 1 to 3, **charac-**

terized in that all the lenses (5) of the lens array have the same width and/or the same centre-to-centre spacing ($P_2$).

5. Device according to one of Claims 1 to 4, **characterized in that** the following condition is valid for the laser radiation (3) and for the lenses (5) of the lens array:

$$\frac{w_0}{d} > 1.1$$

- $w_0$ being the distance in the operating plane (8) between the maximum intensity and the intensity that has dropped to $1/e^2$ of the intensity distribution (19) generated by one of the lenses (5),
- and d being the distance in the operating plane (8) between the maximum intensities of the intensity distributions (19) generated by two neighbouring lenses (5).

6. Device according to one of Claims 1 to 5, **characterized in that** the control means comprise sensor means (14) which can detect the intensity of each of the component beams (6) or groups (7) of component beams (6) emerging from the homogenizing means (1).

7. Device according to Claim 6, **characterized in that** the sensor means (14) are designed as photodiode, photoresistor, phototransistor, photocell or the like.

8. Device according to one of Claims 1 to 7, **characterized in that** the control means comprise comparison means (15) which can compare the intensities of the component beams (6) or groups (7) of component beams (6) emerging from the homogenizing means (1).

9. Laser device, comprising

- at least one laser light source (17), and
- a device for shaping laser radiation (3) in accordance with the preamble of Claim 1,

**characterized in that** the device for shaping laser radiation (3) is a device according to one of Claims 1 to 8.

10. Laser device according to Claim 9, **characterized in that** the laser device comprises at least one power supply (16) for the at least one laser light source (17), and the control means can drive the at least one power supply (16) in such a way that the intensities of the component beams (6) or groups (7) of component beams (6) emerging from the homogenizing means (1) are altered, in particular are matched to one another.

## Revendications

1. Procédé pour la mise en forme de rayonnement laser (3), comprenant

   - des moyens d'homogénéisation (1) qui peuvent homogénéiser séparément une pluralité de faisceaux partiels (6) ou une pluralité de groupes (7) de faisceaux partiels (6) du rayonnement laser (3) de manière à ce que les faisceaux partiels (6) ou groupes (7) de faisceaux partiels (6) provenant des moyens d'homogénéisation (1) puissent respectivement générer dans un plan de travail (8) une distribution d'intensité de forme linéaire (9, 19) présentant des flancs (10) d'extrémité décroissant avec une forte pente aux extrémités des lignes,
   - des moyens de superposition (2) qui comprennent un groupement de lentilles comportant une pluralité de lentilles (5) disposées côte à côte dans une direction d'agencement, dans lequel les moyens de superposition (2) sont utilisés pour superposer les faisceaux partiels (6) ou groupes (7) de faisceaux partiels (6) de manière à ce que, dans le plan de travail (8), il soit possible de générer une distribution d'intensité de forme linéaire (11, 20) dont la longueur dans la direction d'agencement des lentilles (5) est supérieure à la longueur de chacune des distributions d'intensité de forme linéaire (9, 19) des faisceaux partiels (6) ou groupes (7) de faisceaux partiels (6) dans la direction d'agencement des lentilles (5),
   - dans lequel, pour les lentilles (5) du groupement de lentilles, la condition suivante est satisfaite :

$$2 \cdot F \cdot NA(50\ \%) = M \cdot P_2$$

   - avec M = 1, 2, 3,...,
   - dans lequel F est la longueur focale de chacune des lentilles,
   - dans lequel $P_2$ est l'espacement des lentilles,
   - et dans lequel NA(50 %) est l'ouverture numérique de chacune des lentilles (5), définie sur l'angle pour lequel l'intensité de la lumière traversant les lentilles (5) est réduite de moitié,

   - dans lequel les moyens d'homogénéisation (1) et/ou le groupement de lentilles sont agencés et/ou conçus de manière à ce que l'un des faisceaux partiels (6) ou à ce qu'un groupe (7) de faisceaux partiels (6) passe à travers chacune des lentilles (5),

**caractérisé en ce que** le groupement de lentilles des moyens de superposition (2) est un groupement de lentilles monolithique.

2. Dispositif selon la revendication 1, **caractérisé en ce que** le dispositif comprend en outre des moyens de commande qui peuvent agir sur le rayonnement laser (3) de manière à ce que les intensités de chacun des faisceaux partiels (6) provenant des moyens d'homogénéisation (1) ou de chacun des groupes (7) de faisceaux partiels (6) provenant des moyens d'homogénéisation (1) soient identiques.

3. Dispositif selon l'une quelconque des revendications 1 ou 2, **caractérisé en ce que** toutes les lentilles (5) du groupement de lentilles présentent la même longueur focale.

4. Dispositif selon l'une quelconque des revendications 1 à 3, **caractérisé en ce que** toutes les lentilles (5) du groupement de lentilles présentent la même longueur focale et/ou le même espacement ($P_2$).

5. Dispositif selon l'une quelconque des revendications 1 à 4, **caractérisé en ce que**, pour le rayonnement laser (3) et pour les lentilles (5) du groupement de lentilles, la condition suivante est satisfaite :

$$\frac{w_0}{d} > 1,1$$

   - où $w_0$ est la distance dans le plan de travail (8) entre les intensités maximales et l'intensité réduite de $1/e^2$ de la distribution d'intensité (19) générée par l'une des lentilles (5),
   - et où d est la distance dans le plan de travail (8) entre les intensités maximales des distributions d'intensité (19) générées par deux lentilles voisines (5).

6. Dispositif selon l'une quelconque des revendications 1 à 5, **caractérisé en ce que** les moyens de commande comprennent des moyens détecteurs (14) qui peuvent détecter l'intensité de chacun des faisceaux partiels (6) ou groupes (7) de faisceaux partiels (6) provenant des moyens d'homogénéisation (1).

7. Dispositif selon la revendication 6, **caractérisé en ce que** les moyens détecteurs (14) sont réalisés sous la forme de photodiodes, de photorésistances, de phototransistors, de cellules photoélectriques ou autres.

8. Dispositif selon l'une quelconque des revendications 1 à 7, **caractérisé en ce que** les moyens de commande comprennent des moyens comparateurs (15) qui peuvent comparer les intensités des faisceaux partiels (6) ou groupes (7) de faisceaux partiels (6) provenant des moyens d'homogénéisation (1).

9. Dispositif à laser comprenant :

   - au moins une source de lumière laser (17),
   - un dispositif pour la mise en forme de rayonnement laser (3) selon le préambule de la revendication 1, **caractérisé en ce que** le dispositif destiné à la mise en forme de rayonnement laser (3) est un dispositif selon l'une quelconque des revendications 1 à 8.

10. Dispositif à laser selon la revendication 9, **caractérisé en ce que** le dispositif à laser comprend au moins une alimentation en courant (16) destinée à l'au moins une source de lumière laser (17) et **en ce que** les moyens de commande peuvent commander l'au moins une alimentation en courant (16) de manière à ce que les intensités des faisceaux partiels (6) ou groupes (7) de faisceaux partiels (6) provenant des moyens d'homogénéisation (1) puissent être modifiées, et puissent notamment être rendues égales les unes aux autres.

Fig. 1

Fig. 2

Fig. 3

Fig. 4

Fig. 5

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007122061 A1
- US 20070268794 A1
- WO 2008006460 A1